# EUROPEAN PATENT APPLICATION

(11) **EP 4 492 379 A1**
(43) Date of publication of application: **15.01.2025**
(21) Application number: 24162834.6
(22) Date of filing: 12.03.2024
(51) Int. Cl.: G11C 5/02, H01L 25/18, G11C 5/04, G06N 3/063

(54) **MEMORY CHIP AND SEMICONDUCTOR PACKAGE INCLUDING THE SAME**

(30) Priority: 11.07.2023 KR 20230089797
(71) Applicant: Samsung Electronics Co., Ltd., Suwon-si, Gyeonggi-do 16677 (KR)
(72) Inventor: LEE, Jeon Il, 16677 Suwon-si (KR)
(74) Representative: Marks & Clerk LLP

(57) **Abstract**

A memory chip includes a cell chip and a core-periphery chip, which are vertically stacked and are electrically connected to each other. The cell chip includes cell regions, each of which includes a memory cell layer. The core-periphery chip includes a core group region and a peripheral region which are adjacent to each other in a first direction. The core group region includes core regions arranged in a line in a second direction intersecting the first direction. Each of the core regions includes a core bank including a core circuit, and a neural processing unit (NPU) block including an NPU.

## Description

### BACKGROUND

### 1. Field

Embodiments of the present disclosure relate to a memory chip and a semiconductor package including the same.

### 2. Description of Related Art

A memory chip may include a plurality of circuit regions therein. For example, the memory chip may have a cell region for performing a memory function, and core and peripheral regions on which circuits for driving the cell region and inputting/outputting data are formed. Meanwhile, more circuits should be formed on a limited chip region to improve an integration density of the memory chip. Thus, various research is being conducted to develop a memory chip capable of reducing a form factor and improving performance, and a semiconductor package including the same.

### SUMMARY

Embodiments of the present disclosure may provide a memory chip with an improved integration density and a semiconductor package including the same.

Embodiments of the present disclosure may also provide a memory chip with improved performance and a semiconductor package including the same.

According to embodiments of the present disclosure, a memory chip is provided and includes: a cell chip; and a core-periphery chip, wherein the cell chip and the core-periphery chip are vertically stacked and are electrically connected to each other, wherein the cell chip includes cell regions, each of the cell regions including a memory cell layer, wherein the core-periphery chip includes at least one core group region and a peripheral region which are adjacent to each other in a first direction, wherein the at least one core group region includes core regions arranged in a line in a second direction intersecting the first direction, and wherein each of the core regions includes a core bank including a core circuit; and a neural processing unit (NPU) block including an NPU.

According to embodiments of the present disclosure, a semiconductor package is provided and includes: cell chips; core-periphery chips; and through-silicon vias (TSVs) electrically connecting the cell chips and the core-periphery chips to each other, wherein the cell chips and the core-periphery chips are alternately stacked, wherein each of the cell chips includes a cell region for storing data, and wherein each of the core-periphery chips includes a neural processing unit (NPU) block that is configured to perform data operations.

According to embodiments of the present disclosure, a semiconductor package is provided and includes: a plurality of memory chips stacked vertically; and through-silicon vias (TSVs) electrically connecting the plurality of memory chips, wherein each of the plurality of memory chips includes a cell chip and a core-periphery chip which are vertically stacked, wherein the cell chip includes: cell regions, each of the cell regions including a memory cell layer, wherein the core-periphery chip includes at least one core group region and a peripheral region which are adjacent to each other in a first direction, wherein the at least one core group region includes core regions arranged in a line in a second direction intersecting the first direction, and wherein each of the core regions includes a core bank including a core circuit; and a neural processing unit (NPU) block including an NPU.

According to embodiments of the present disclosure, a semiconductor package is provided and includes: a package substrate; a host structure on the package substrate; and a memory structure horizontally spaced apart from the host structure on the package substrate and electrically connected to the host structure, wherein the memory structure includes a plurality of memory chips stacked vertically, wherein each of the plurality of memory chips includes a cell chip and a core-periphery chip which are vertically stacked and are electrically connected to each other, wherein the cell chip includes cell regions, each the cell regions including a memory cell layer, wherein the core-periphery chip includes at least one core group region and a peripheral region which are adjacent to each other in a first direction, wherein the at least one core group region includes core regions arranged in a line in a second direction intersecting the first direction, and wherein each of the core regions includes a core bank including a core circuit; and a neural processing unit (NPU) block including an NPU.

At least some of the above and other features of the invention are set out in the claims.

### BRIEF DESCRIPTION OF DRAWINGS

FIGS. 1 and 2 are perspective views illustrating memory chips according to some embodiments of the present disclosure.
FIGS. 3 to 10 are plan views illustrating core-periphery chips of memory chips according to some embodiments of the present disclosure.
FIGS. 11 to 14 are plan views illustrating cell chips of memory chips according to some embodiments of the present disclosure.
FIGS. 15A to 17B are cross-sectional views illustrating memory chips according to some embodiments of the present disclosure.
FIG. 18 is a cross-sectional view illustrating a plurality of memory chips according to some embodiments of the present disclosure.
FIG. 19 is a cross-sectional view illustrating a semiconductor package including a memory chip according to some embodiments of the present disclosure.
FIG. 20 is a cross-sectional view illustrating a semiconductor package including a memory chip according to some embodiments of the present disclosure.

### DETAILED DESCRIPTION

Embodiments of the present disclosure will now be described more fully with reference to the accompanying drawings.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present. As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

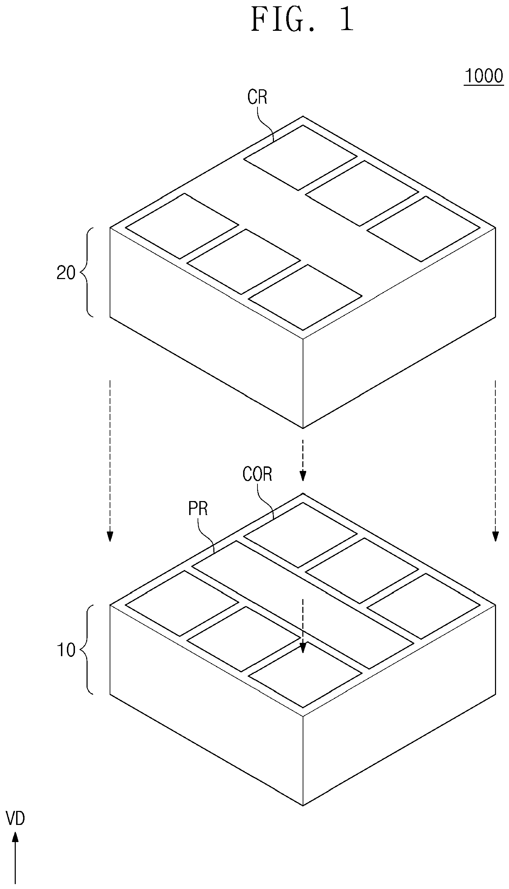

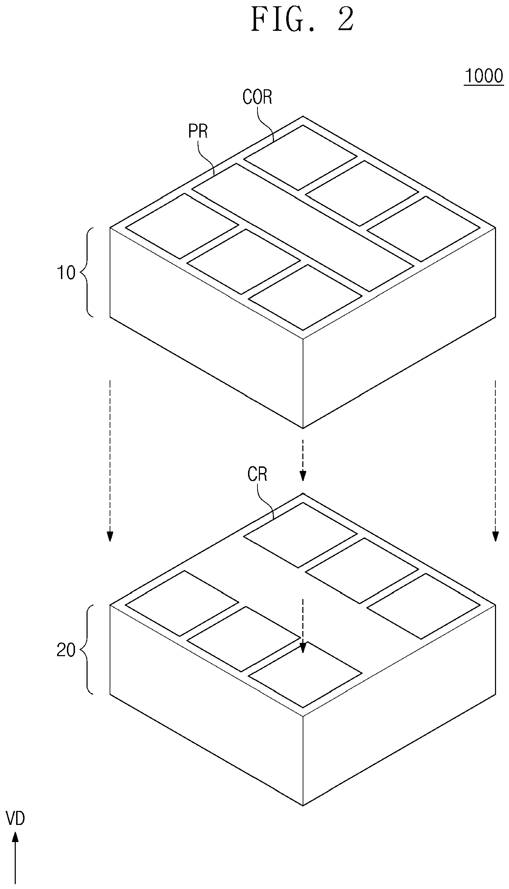

FIGS. 1 and 2 are perspective views illustrating memory chips according to some embodiments of the present disclosure.

Referring to FIGS. 1 and 2, a memory chip 1000 may include a core-periphery chip 10 and a cell chip 20, which are stacked in a vertical direction VD. The vertical direction VD may be a direction running perpendicular to an upper or lower surface of a substrate of each of the core-periphery chip 10 and cell chip 20. The core-periphery chip 10 and the cell chip 20 may vertically overlap with each other. In some embodiments, as shown in FIG. 1, the cell chip 20 may be stacked on the core-periphery chip 10. In certain embodiments, as shown in FIG. 2, the core-periphery chip 10 may be stacked on the cell chip 20.

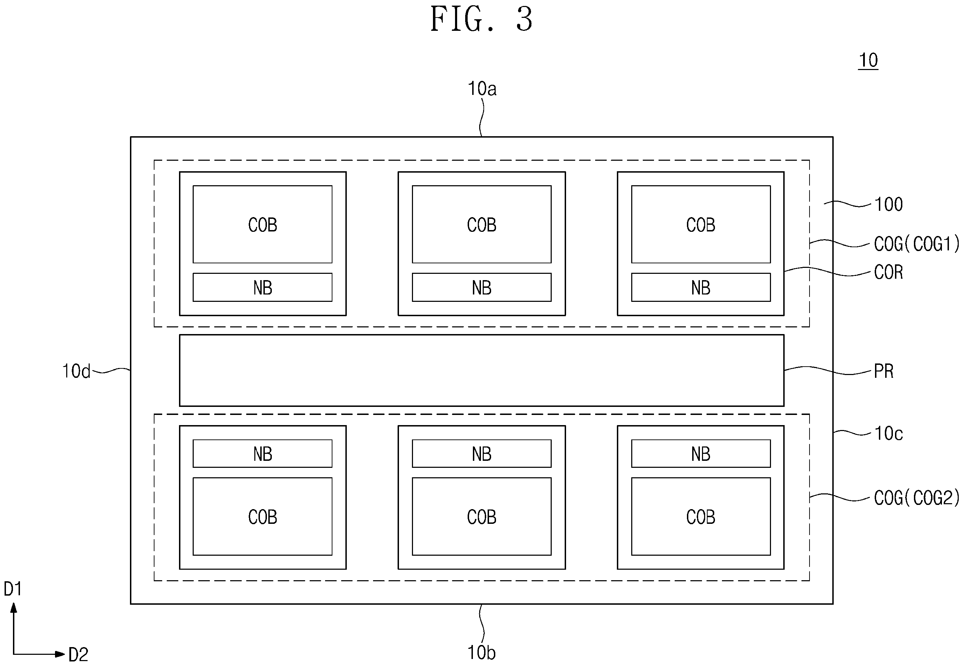

The core-periphery chip 10 may include core regions COR and a peripheral region PR, when viewed in a plan view (e.g. when viewed along the vertical direction VD). The core regions COR and the peripheral region PR may be adjacent to each other in a horizontal direction. A horizontal direction may be a direction perpendicular to the vertical direction VD. The horizontal direction may be parallel to an upper or lower surface of a substrate of each of the core-periphery chip 10 and cell chip 20. Each of the core regions COR may include a core bank COB (refer to FIGS. 3-9) to be described below, and the core bank COB may include core circuits such as a sub-word line driver, a sense amplifier, a row decoder, a column decoder, and a read/write (R/W) circuit. The peripheral region PR may include peripheral circuits such as a timing register, an address register, a data input register, a data output register, and a data input/output terminal.

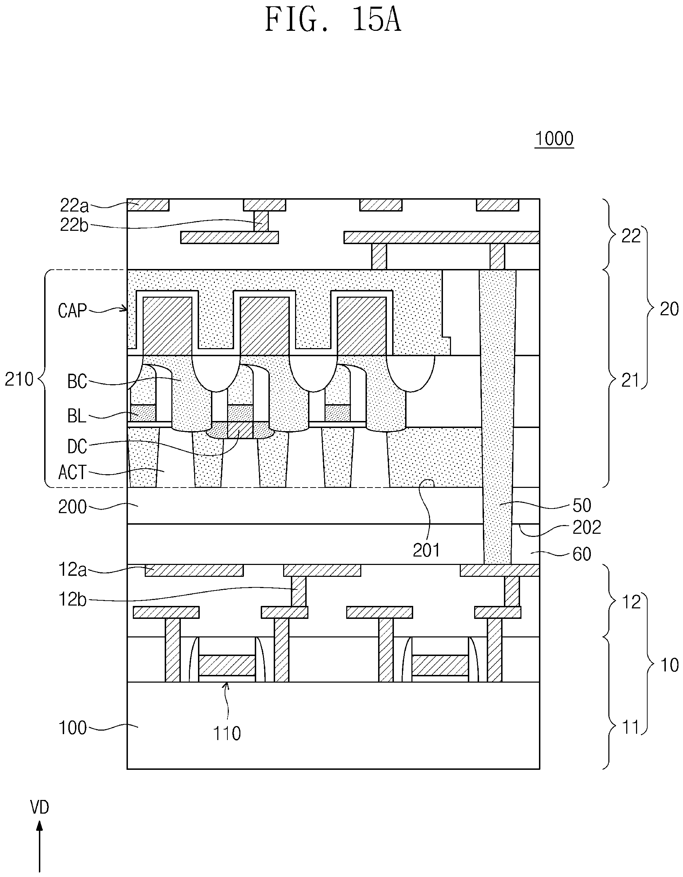

The cell chip 20 may include cell regions CR, when viewed in a plan view. As described herein, a plan view may be a view along the vertical direction (e.g. a view of a horizontal plane). The cell regions CR may be adjacent to each other in a horizontal direction. Each of the cell regions CR may vertically overlap with at least a portion of each of the core regions COR. Each of the cell regions CR may include a memory cell layer 210 (refer to FIGS. 15A-17B) to be described below, and the memory cell layer 210 may store data.

Hereinafter, planar arrangements of components in the core-periphery chip 10 and the cell chip 20 will be described in more detail.

FIGS. 3 to 10 are plan views illustrating core-periphery chips of memory chips according to some embodiments of the present disclosure.

Referring to FIGS. 3 to 10, the core-periphery chip 10 may have a first side surface 10a facing a first direction D1, a second side surface 10b opposite to the first side surface 10a, a third side surface 10c facing a second direction D2, and a fourth side surface 10d opposite to the third side surface 10c. The first direction D 1 and the second direction D2 may be parallel to a bottom surface of the core-periphery chip 10 and may intersect each other. The first direction D1 and the second direction D2 may be horizontal directions.

Each of the core regions COR may include the core bank COB and a neural processing unit (NPU) block NB. The NPU block NB may include a neural processing unit (NPU) that is configured to perform data operations. For example, one core region COR may include one core bank COB and one NPU block NB, and the one core bank COB and the one NPU block NB may be adjacent to each other in the first direction D1 or the second direction D2. Since the core regions COR include the NPU blocks NB, the memory chip 1000 may function as a processing in memory (PIM) capable of performing data operations. Data operations may comprise one or more arithmetic operations (e.g. one or more inference operations). In one embodiment, an NPU may comprise circuitry that is particularly configured to perform artificial intelligence and/or machine learning operations. For instance, an NPU may be configured to perform simultaneous matrix operations, which may form part of the operation of an artificial neural network. For example, the NPU may be configured to perform a function used for inference. Here, the inference may be performed in a deep learning algorithm using an artificial neural network. The deep learning algorithm may include a training operation of learning a model through various data and an inference operation of recognizing data with the learned model. For example, the function used for inference may include a hyperbolic tangent function, a sigmoid function, a rectified linear unit (ReLU) function, and the like.

The peripheral region PR may be located on a central portion of the core-periphery chip 10. The central portion of the core-periphery chip 10 may be defined as a region of the core-periphery chip 10, which is disposed at equal distances from the first side surface 10a and the second side surface 10b of the core-periphery chip 10 and is disposed at equal distances from the third side surface 10c and the fourth side surface 10d of the core-periphery chip 10. The peripheral region PR may be a region extending long in the second direction D2 on the central portion of the core-periphery chip 10.

The core regions COR may include the core regions COR arranged in a line in the second direction D2. The core regions COR arranged in the line may constitute a core group region COG. The core group region COG may be adjacent to the peripheral region PR in the first direction D1 or an opposite direction to the first direction D1.

The core group region COG may be provided in plural. The plurality of core group regions COG may be sequentially arranged in the first direction D1. In other words, the core regions COR arranged in a line may be provided, and the core regions COR arranged in another line may be disposed to be spaced apart from the core regions COR arranged in the line, in the first direction D1.

For example, the core group regions COG may include a first group COG1 adjacent to the peripheral region PR in the first direction D1, and a second group COG2 adjacent to the peripheral region PR in the opposite direction to the first direction D1. The first group COG1 and the second group COG2 may be spaced apart from each other in the first direction D1 with the peripheral region PR interposed therebetween. The first group COG1 may be located between the peripheral region PR and the first side surface 10a of the core-periphery chip 10. The second group COG2 may be located between the peripheral region PR and the second side surface 10b of the core-periphery chip 10.

Referring to FIG. 3, the core banks COB and the NPU blocks NB may be disposed symmetrically with respect to the peripheral region PR (i.e., a line perpendicular to the first direction D1). For example, the NPU block NB and the core bank COB of the first group COG1 may be sequentially arranged from the peripheral region PR in the first direction D1. The NPU block NB and the core bank COB of the second group COG2 may be sequentially arranged from the peripheral region PR in the opposite direction to the first direction D1. In other words, the core bank COB and the NPU block NB of the first group COG1 and the core bank COB and the NPU block NB of the second group COG2 may be disposed symmetrically with respect to the peripheral region PR. The NPU block NB of the first group COG1 may be located between the peripheral region PR and the core bank COB of the first group COG1. The NPU block NB of the second group COG2 may be located between the peripheral region PR and the core bank COB of the second group COG2.

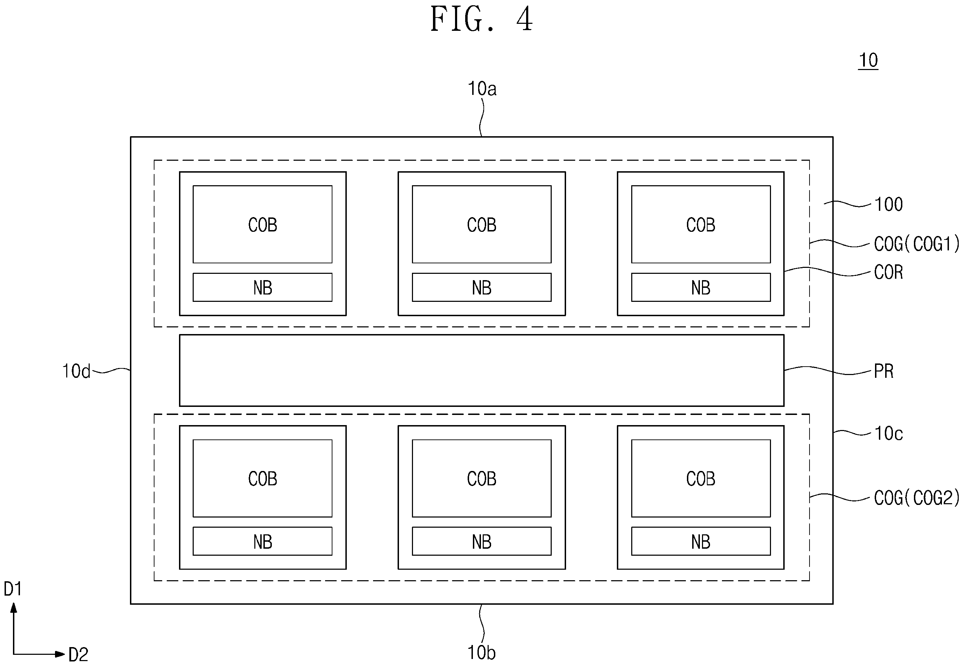

Referring to FIG. 4, the core banks COB and the NPU blocks NB may be disposed asymmetrically with respect to the peripheral region PR (i.e., the line perpendicular to the first direction D1). For example, the NPU block NB and the core bank COB of the first group COG1 may be sequentially arranged from the peripheral region PR in the first direction D1 (e.g. the NPU block NB of the first group COG1 may be located between the peripheral region PR and the core bank COB of the first group COG1). The core bank COB and the NPU block NB of the second group COG2 may be sequentially arranged from the peripheral region PR in the opposite direction to the first direction D1 (e.g. the core bank COB of the second group COG2 may be located between the peripheral region PR and the NPU block NB of the second group COG2.). In other words, the NPU block NB and the core bank COB of each of the first group COG1 and the second group COG2 may be sequentially arranged in the first direction D1. For example, an arrangement order of the NPU block NB and the core bank COB in the first group COG1 may be the same as an arrangement order of the NPU block NB and the core bank COB in the second group COG2.

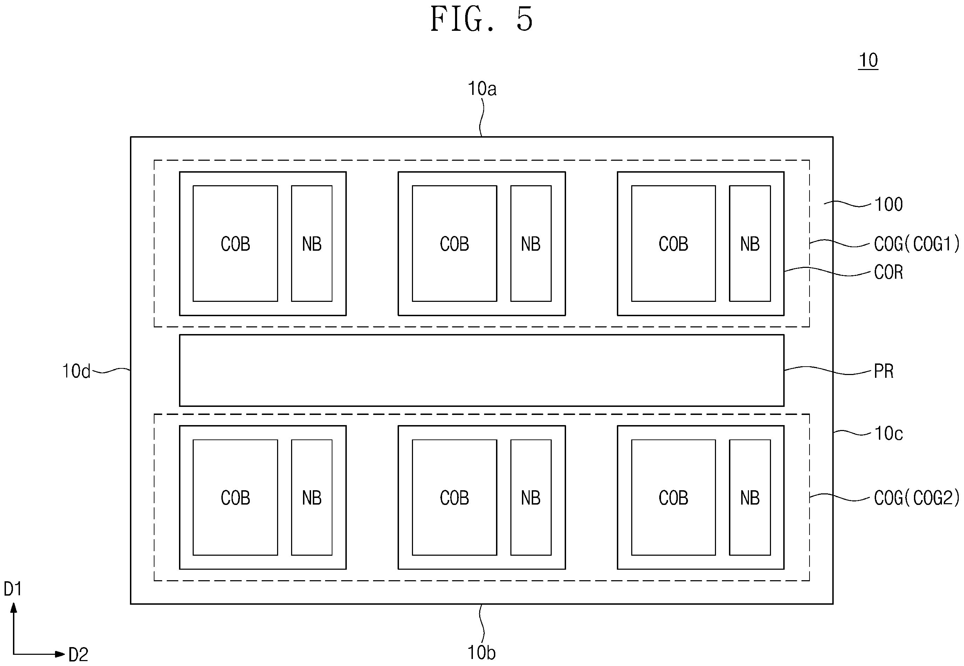

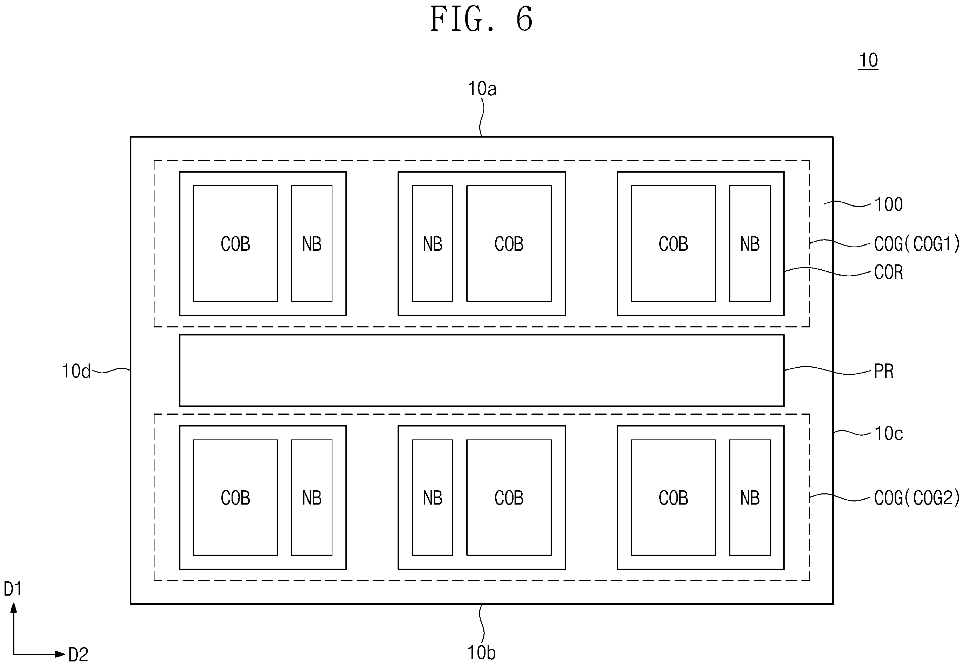

Referring to FIGS. 5 and 6, the core bank COB and the NPU block NB in each of the core regions COR may be adjacent to each other in the second direction D2.

In some embodiments, as shown in FIG. 5, a pair of the core regions COR may be adjacent to each other in the second direction D2, and the core bank COB and the NPU block NB of each of the pair of core regions COR may be sequentially arranged in the second direction D2. In other words, the core banks COB and the NPU blocks NB of the pair of core regions COR may be disposed asymmetrically with respect to a line perpendicular to the second direction D2 (a line parallel to the first direction D1). For example, the pair of core regions COR may have the same arrangement order of the core bank COB and the NPU block NB.

In certain embodiments, as shown in FIG. 6, the core bank COB and the NPU block NB of one of the pair of core regions COR may be sequentially arranged in the second direction D2, and the core bank COB and the NPU block NB of the other of the pair of core regions COR may be sequentially arranged in an opposite direction to the second direction D2. In other words, the core banks COB and the NPU blocks NB of the pair of core regions COR may be disposed symmetrically with respect to the line perpendicular to the second direction D2. For example, an arrangement order of the core bank COB and the NPU block NB in the one core region COR from among the pair of core regions COR may be opposite to an arrangement order of the core bank COB and the NPU block NB in the other core region COR from among the pair of core regions COR.

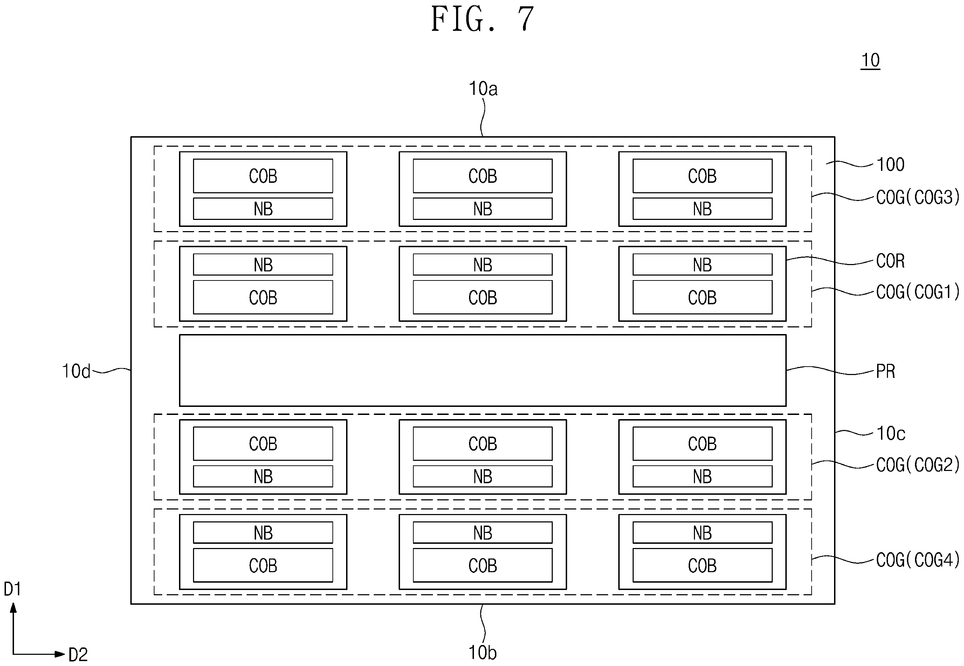

Referring to FIGS. 7 to 9, a plurality of the core group regions COG may be located between the peripheral region PR and the first side surface 10a of the core-periphery chip 10, and another plurality of the core group regions COG may be located between the peripheral region PR and the second side surface 10b of the core-periphery chip 10. For example, as shown in FIGS. 7 to 9, the core group regions COG may include a first group COG1, a second group COG2, a third group COG3 and a fourth group COG4. The first group COG1 may be located between the peripheral region PR and the first side surface 10a of the core-periphery chip 10. The second group COG2 may be located between the peripheral region PR and the second side surface 10b of the core-periphery chip 10. The third group COG3 may be located between the first group COG1 and the first side surface 10a of the core-periphery chip 10 and may be adjacent to the first group COG1 in the first direction D 1. The fourth group COG4 may be located between the second group COG2 and the second side surface 10b of the core-periphery chip 10 and may be adjacent to the second group COG2 in the first direction D1. However, embodiments of the present disclosure are not limited thereto, and in certain embodiments, the core group regions COG may further include additional groups such as fifth and sixth groups.

Referring to FIG. 7, the core banks COB and the NPU blocks NB may be disposed symmetrically with respect to the peripheral region PR (i.e., a line which is perpendicular to the first direction D1 and passes through the peripheral region PR). The core bank COB and the NPU block NB of the first group COG1 may be sequentially arranged in the first direction D1. The core bank COB and the NPU block NB of the second group COG2 may be sequentially arranged in the opposite direction to the first direction D1. Thus, the second group COG2 and the first group COG1 may be symmetrical with respect to the peripheral region PR.

The NPU block NB and the core bank COB of the third group COG3 may be sequentially arranged in the first direction D1. Thus, the first group COG1 and the third group COG3 may be disposed symmetrically with respect to a line which is perpendicular to the first direction D1 and passes through a center between the first group COG1 and the third group COG3.

The NPU block NB and the core bank COB of the fourth group COG4 may be sequentially arranged in the opposite direction to the first direction D1. Thus, the second group COG2 and the fourth group COG4 may be disposed symmetrically with respect to a line which is perpendicular to the first direction D1 and passes through a center between the second group COG2 and the fourth group COG4. In addition, the fourth group COG4 and the third group COG3 may be symmetrical with respect to the peripheral region PR.

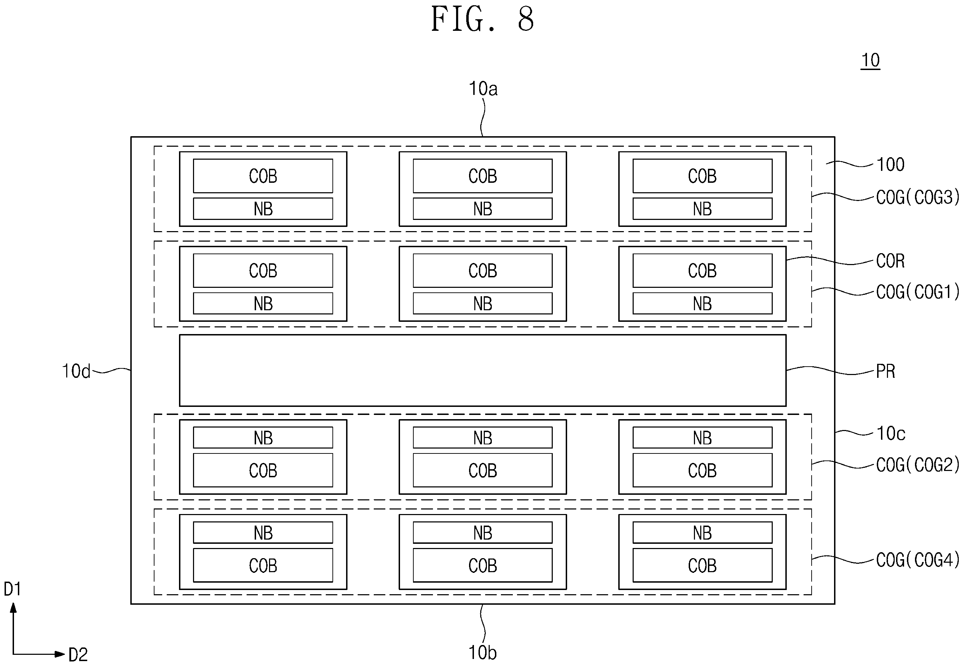

Referring to FIG. 8, like FIG. 7, the core banks COB and the NPU blocks NB may be disposed symmetrically with respect to the peripheral region PR (i.e., the line which is perpendicular to the first direction D1 and passes through the peripheral region PR). However, unlike FIG. 7, the NPU block NB and the core bank COB of the first group COG1 may be sequentially arranged in the first direction D1, and the NPU block NB and the core bank COB of the second group COG2 may be sequentially arranged in the opposite direction to the first direction D1. Thus, the first group COG1 and the third group COG3 may be disposed asymmetrically with respect to the line which is perpendicular to the first direction D1 and passes through the center between the first group COG1 and the third group COG3, and the second group COG2 and the fourth group COG4 may be disposed asymmetrically with respect to the line which is perpendicular to the first direction D1 and passes through the center between the second group COG2 and the fourth group COG4. For example, the first group COG1 and the third group COG3 may have the same arrangement order of the NPU block NB and the core bank COB. For example, the second group COG2 and the fourth group COG4 may have the same arrangement order of the NPU block NB and the core bank COB.

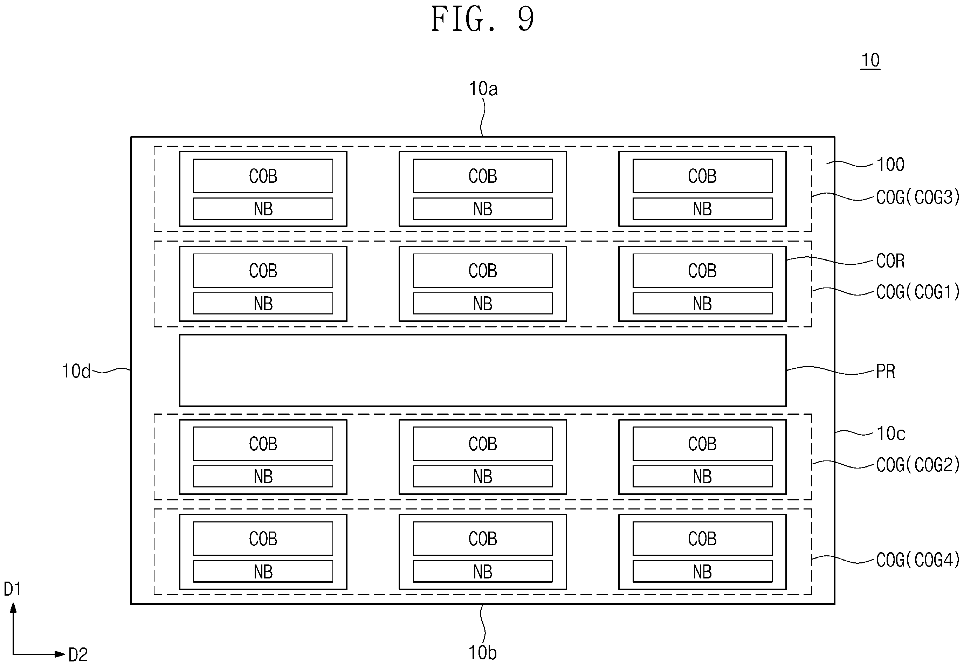

Referring to FIG. 9, the core banks COB and the NPU blocks NB may be disposed asymmetrically with respect to the peripheral region PR (i.e., the line which is perpendicular to the first direction D1 and passes through the peripheral region PR). For example, the NPU block NB and the core bank COB of each of the first group COG1, the second group COG2, the third group COG3, and the fourth group COG4 may be sequentially arranged in the first direction D1. In other words, the first group COG1, the second group COG2, the third group COG3, and the fourth group COG4 may have the same arrangement order of the NPU block NB and the core bank COB. The first group COG1 and the third group COG3 may be disposed asymmetrically with respect to the line which is perpendicular to the first direction D1 and passes through the center between the first group COG1 and the third group COG3, and the second group COG2 and the fourth group COG4 may be disposed asymmetrically with respect to the line which is perpendicular to the first direction D1 and passes through the center between the second group COG2 and the fourth group COG4.

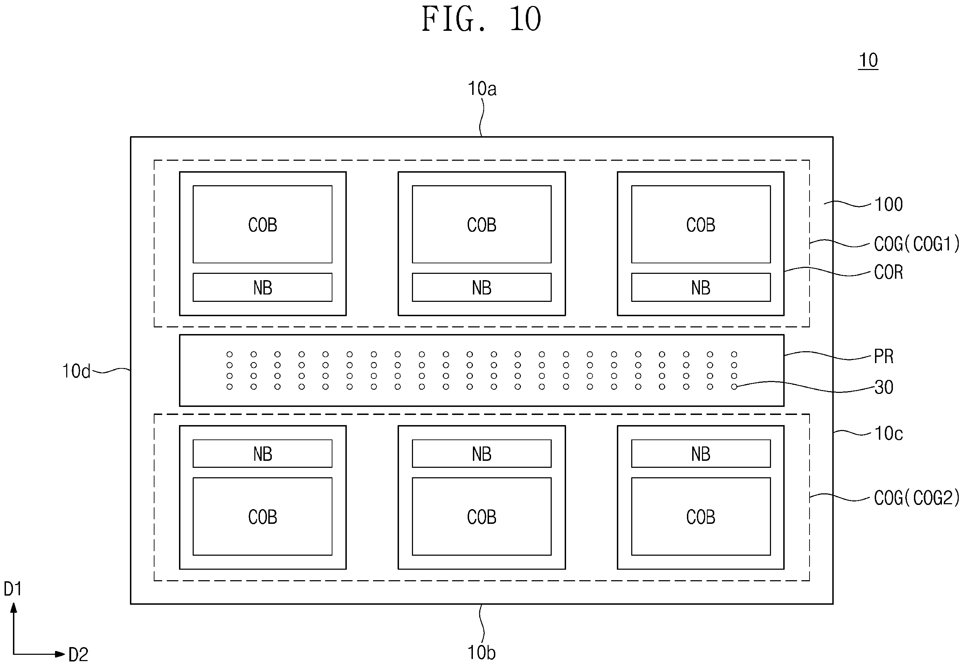

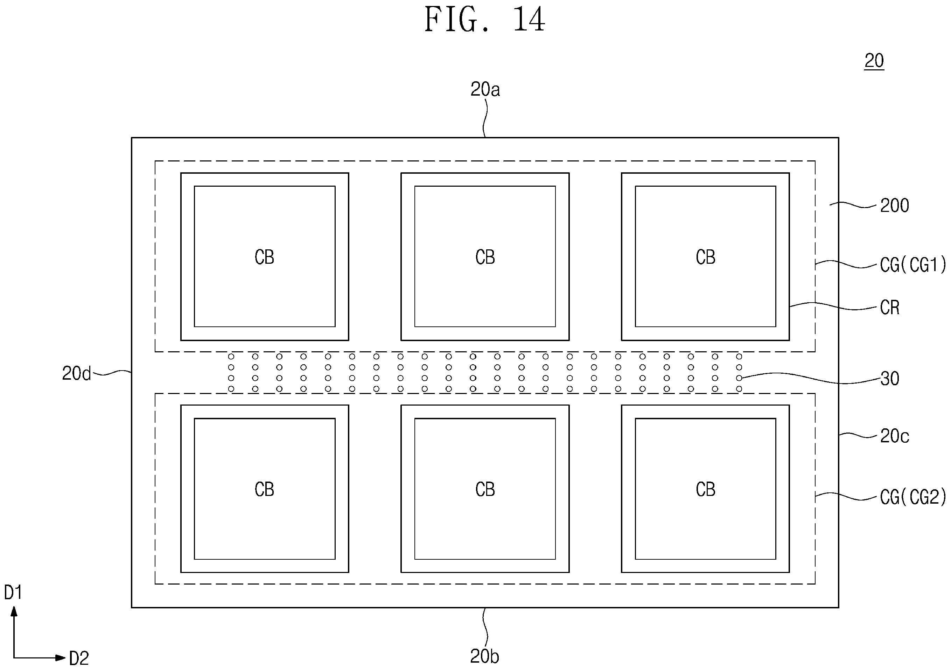

Referring to FIG. 10, the core-periphery chip 10 may further include through-silicon vias (TSVs) 30 located in a central portion thereof. The TSVs 30 may be located in the peripheral region PR. The TSVs 30 may be located between the first group COG1 and the second group COG2. The TSVs 30 may be distributed in a region extending long (e.g. elongated) in the second direction D2 on the central portion of the core-periphery chip 10. Each of the TSVs 30 may vertically extend in the core-periphery chip 10, and for example, each of the TSVs 30 may penetrate at least a portion of the core-periphery chip 10. The TSVs 30 of the core-periphery chip 10 may be electrically connected to TSVs 30 of the cell chip 20 (refer to FIG. 14). In other words, the core-periphery chip 10 and the cell chip 20 of the memory chip 1000 may be electrically connected to each other.

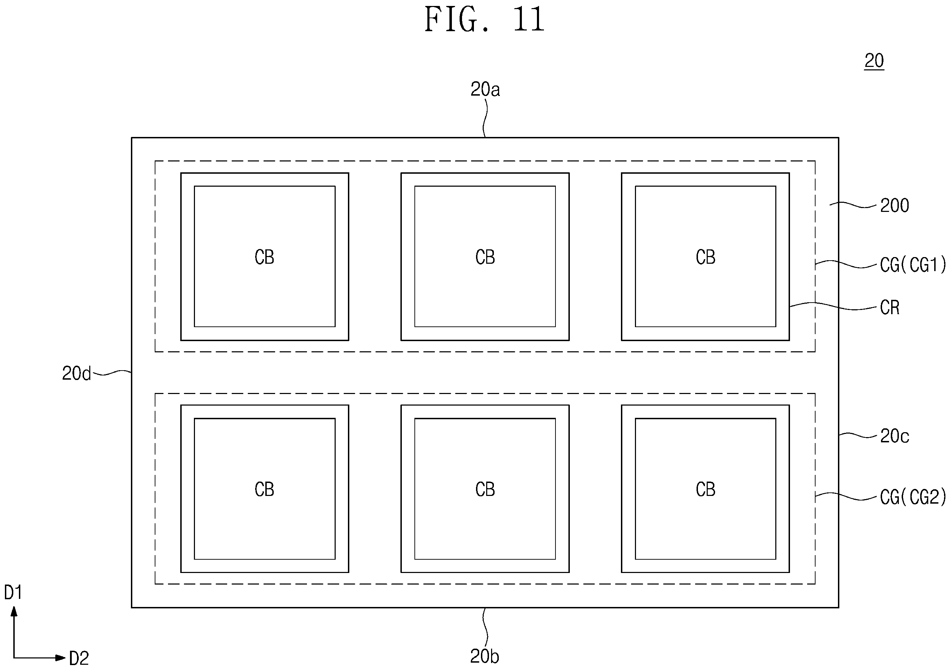

FIGS. 11 to 14 are plan views illustrating cell chips of memory chips according to some embodiments of the present disclosure.

Referring to FIGS. 11 to 14, the cell chip 20 may have a first side surface 20a facing the first direction D1, a second side surface 20b opposite to the first side surface 20a, a third side surface 20c facing the second direction D2, and a fourth side surface 20d opposite to the third side surface 20c.

Each of the cell regions CR may include a cell bank CB. The cell bank CB may include the memory cell layer 210 (refer to FIGS. 15A-17B) to be described below in detail, and the memory cell layer 210 may be configured to store data. For example, each of the cell regions CR may vertically overlap with at least a portion of each of the NPU blocks NB of the core-periphery chip 10. Thus, a distance between the cell region CR and the NPU block NB may be reduced as compared with a case in which a cell region and an NPU block do not overlap with each other. As a result, a data processing speed of the memory chip 1000 may be improved. In addition, the memory chip 1000 may be driven by low power, and issues such as noise and/or heat generation may be reduced or minimized.

The cell regions CR may be arranged in the first direction D1 and the second direction D2. For example, the cell regions CR may include the cell regions CR arranged in a line in the second direction D2. The cell regions CR arranged in the line may constitute a cell group region CG. The cell group region CG may be provided in plural, and the cell group regions CG may be adjacent to each other in the first direction D1.

For example, the cell group regions CG may include a first group CG1 adjacent to a central portion of the cell chip 20 in the first direction D1, and a second group CG2 adjacent to the central portion of the cell chip 20 in the opposite direction to the first direction D1. The central portion of the cell chip 20 may be defined as a region of the cell chip 20 which is disposed at equal distances from the first side surface 20a and the second side surface 20b of the cell chip 20 and is disposed at equal distances from the third side surface 20c and the fourth side surface 20d of the cell chip 20. The first group CG1 and the second group CG2 may be spaced apart from each other in the first direction D1 with the central portion of the cell chip 20 interposed therebetween. The first group CG1 may be located between the first side surface 20a of the cell chip 20 and the central portion. The second group CG2 may be located between the second side surface 20b of the cell chip 20 and the central portion. In certain embodiments, the cell group regions CG may further include additional groups such as third and fourth groups. The third group may be located between the first group CG1 and the first side surface 20a of the cell chip 20, and the fourth group may be located between the second group CG2 and the second side surface 20b of the cell chip 20.

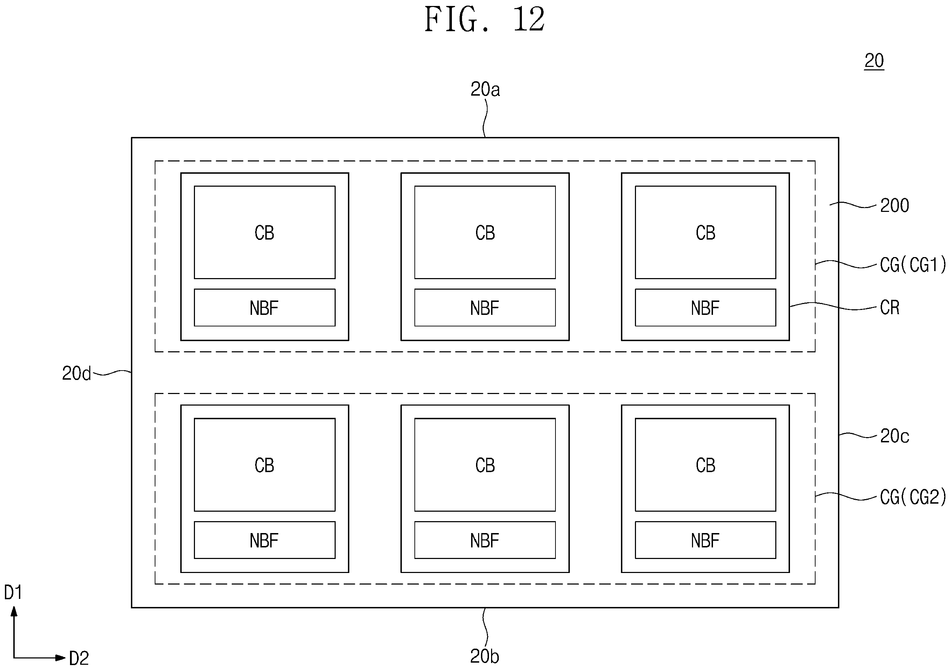

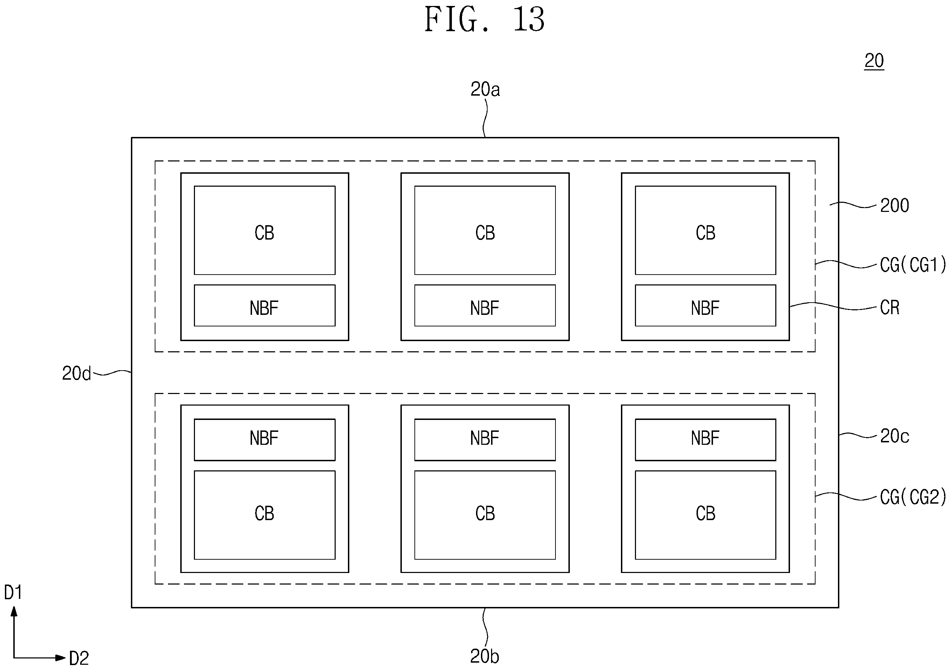

Referring to FIGS. 12 and 13, each of the cell regions CR may further include an NPU buffer NBF. The NPU buffer NBF may include an NPU buffer memory used to drive the NPU. The NPU buffer memory may include at least one of new memories (e.g., a phase-change random access memory (RAM) (PRAM) device, a spin transfer torque magnetic RAM (STT-MRAM) device, and a ferroelectric RAM (FeRAM) device), and a static RAM (SRAM) device.

For example, one cell region CR may include one cell bank CB and one NPU buffer NBF. The cell bank CB and the NPU buffer NBF may be adjacent to each other in a horizontal direction (e.g., the first direction D1 or the second direction D2). Since the NPU buffer NBF is located on the cell region CR, an area of the NPU block NB in the core-periphery chip 10 may be reduced. Thus, integration densities in the core-periphery chip 10 and the cell chip 20 may be appropriately adjusted by the NPU buffer NBF, thereby improving or maximizing an integration density of the memory chip 1000.

Referring to FIG. 12, the cell banks CB and the NPU buffers NBF may be disposed asymmetrically with respect to the central portion of the cell chip 20 (i.e., a line which is perpendicular to the first direction D1 and passes through the central portion of the cell chip 20). For example, all of the cell regions CR may have the same arrangement order of the cell bank CB and the NPU buffer NBF.

Referring to FIG. 13, the cell banks CB and the NPU buffers NBF may be disposed symmetrically with respect to the central portion of the cell chip 20 (i.e., the line which is perpendicular to the first direction D1 and passes through the central portion of the cell chip 20). For example, the NPU buffer NBF and the cell bank CB of the first group CG1 may be sequentially arranged from the central portion of the cell chip 20 in the first direction D1, and the NPU buffer NBF and the cell bank CB of the second group CG2 may be sequentially arranged from the central portion of the cell chip 20 in the opposite direction to the first direction D1. In other words, the NPU buffer NBF and the cell bank CB of the first group CG1 and the NPU buffer NBF and the cell bank CB of the second group CG2 may be disposed symmetrically with respect to the central portion of the cell chip 20. Generally, the NPU buffer NBF may be positioned to vertically overlap a corresponding NPU block NB (e.g. may be positioned directly above or directly below the corresponding NPU block NB). Similarly, the cell bank CB may be positioned to vertically overlap a corresponding core bank COB (e.g. may be positioned directly above or directly below the corresponding core bank COB). Accordingly, the arrangement of NPU buffers NBF and cell banks CB in the cell chip 20 may be equivalent to the arrangement of NPU blocks NB and core banks COB in the core-periphery chip 10.

Referring to FIG. 14, the cell chip 20 may further include TSVs 30 located in its central portion. The TSVs 30 may be located between the first group CG1 and the second group CG2. The TSVs 30 may be distributed in a region extending long in the second direction D2 on the central portion of the cell chip 20. Each of the TSVs 30 may vertically extend in the cell chip 20, and for example, each of the TSVs 30 may penetrate at least a portion of the cell chip 20. The TSVs 30 of the cell chip 20 may be electrically connected to the TSVs 30 of the core-periphery chip 10. The TSVs 30 of the core-periphery chip 10 and the cell chip 20 may be electrically connected to an external device and may be used to transmit electrical signals from the external device to the chips.

FIGS. 15A to 17B are cross-sectional views illustrating memory chips according to some embodiments of the present disclosure.

Referring to FIGS. 15A to 17B, the core-periphery chip 10 may include a driving layer 11 and a core-periphery interconnection layer 12. The core-periphery interconnection layer 12 may be provided on the driving layer 11.

The driving layer 11 may include a core-periphery semiconductor layer 100 and core-periphery transistors 110 on the core-periphery semiconductor layer 100. The core-periphery semiconductor layer 100 may include a semiconductor material. For some examples, the core-periphery semiconductor layer 100 may be a semiconductor substrate including a semiconductor material, such as a single-crystalline silicon substrate, a silicon-germanium substrate or a silicon on insulator (SOI) substrate. For certain examples, the core-periphery semiconductor layer 100 may be a semiconductor epitaxial layer including a semiconductor material. The core-periphery transistors 110 may be transistors provided in a core circuit, a peripheral circuit and the NPU. The core-periphery transistor 110 is illustrated as a planar type transistor, but in certain embodiments, a transistor having other shape may be applied to the core-periphery transistor 110.

The core-periphery interconnection layer 12 may include core-periphery circuit lines 12a and core-periphery contact plugs 12b electrically connecting the core-periphery transistors 110 to the core-periphery circuit lines 12a.

The cell chip 20 may include a data storage layer 21 and a cell interconnection layer 22. The data storage layer 21 may include a cell semiconductor layer 200 and a memory cell layer 210. The cell semiconductor layer 200 may include a first surface 201 and a second surface 202, which are opposite to each other in the vertical direction VD. The first surface 201 of the cell semiconductor layer 200 may be a front surface of the cell semiconductor layer 200, and the memory cell layer 210 may be formed on the front surface of the cell semiconductor layer 200. The second surface 202 of the cell semiconductor layer 200 may be a back surface of the cell semiconductor layer 200.

The cell semiconductor layer 200 may include a semiconductor material. For some examples, the cell semiconductor layer 200 may be a semiconductor substrate including a semiconductor material, such as a single-crystalline silicon substrate, a silicon-germanium substrate or a SOI substrate. For certain examples, the cell semiconductor layer 200 may be a semiconductor epitaxial layer including a semiconductor material. The memory cell layer 210 may include at least one of various kinds of semiconductor memories. In some embodiments, the memory cell layer 210 may include a two-dimensional (2D) memory such as a DRAM having a buried channel array transistor (BCAT) structure or a vertical channel transistor (VCT) structure. In certain embodiments, the memory cell layer 210 may include a three-dimensional (3D) memory such as a vertically stacked DRAM (VS DRAM), a 3D ferroelectric FET (3D FeFET), or a 3D monolithic memory.

In some embodiments, as shown in FIGS. 15A, 16A and 17A, the memory cell layer 210 may include a DRAM having a BCAT structure including an active region ACT, a bit line node contact DC, a bit line BL, a storage node contact BC, and a capacitor CAP. Here, a word line may be provided below a top surface of the active region ACT and may intersect the active region ACT.

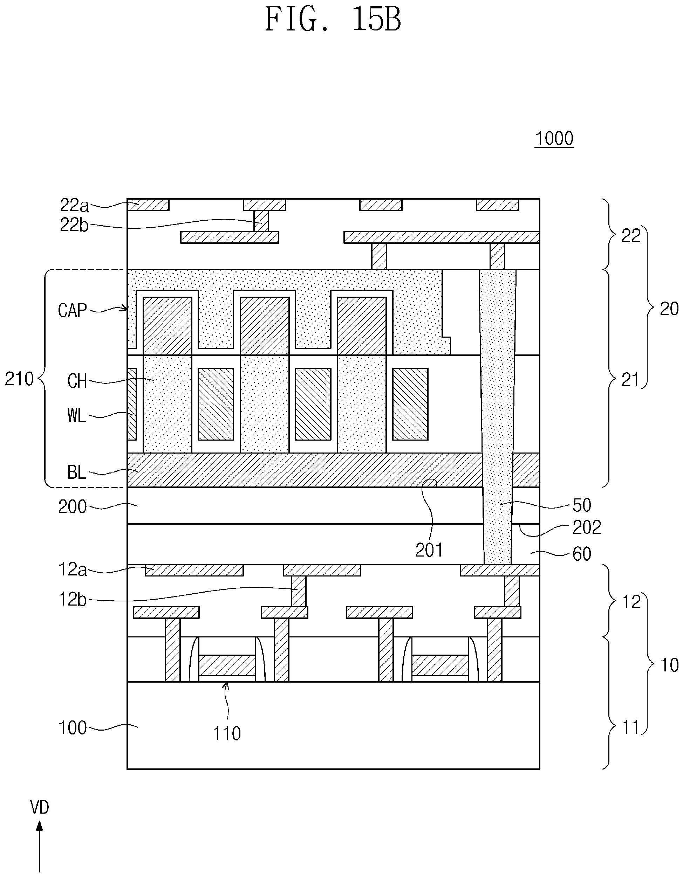

In certain embodiments, as shown in FIGS. 15B, 16B and 17B, the memory cell layer 210 may include a DRAM having a VCT structure including a bit line BL, a channel pattern CH, a word line WL, and a capacitor CAP. Here, the channel pattern CH may include at least one from among single-crystalline silicon, poly-silicon, an oxide semiconductor material (e.g., InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, InxGayO, etc.), and a two-dimensional material (e.g., graphene, a transition metal dichalcogenide (TMD) including a transition metal element (e.g., Mo, W, V, Nb, Ta, Ti, etc.) and a chalcogen element (e.g., S, Se, Te, etc.), etc.).

The cell interconnection layer 22 may include cell circuit lines 22a and cell contact plugs 22b electrically connecting the memory cell layer 210 to the cell circuit lines 22a.

Referring to FIGS. 15A and 15B, the data storage layer 21 may be disposed on the core-periphery chip 10, and the cell interconnection layer 22 may be disposed on the data storage layer 21. The data storage layer 21 may be disposed between the core-periphery chip 10 and the cell interconnection layer 22.

The memory cell layer 210 and the cell interconnection layer 22 may be sequentially provided on the first surface 201 of the cell semiconductor layer 200. The core-periphery chip 10 may be provided on the second surface 202 of the cell semiconductor layer 200. In other words, the cell semiconductor layer 200, the memory cell layer 210, and the cell interconnection layer 22 may be sequentially stacked on the core-periphery chip 10. A chip insulating layer 60 may be disposed between the second surface 202 of the cell semiconductor layer 200 and the core-periphery chip 10.

A through-conductive pattern 50 may electrically connect the core-periphery chip 10 to the cell chip 20. The through-conductive pattern 50 may penetrate the cell chip 20 and the chip insulating layer 60 in the vertical direction VD and may extend to the core-periphery chip 10. For example, the through-conductive pattern 50 may be electrically connected to the cell interconnection layer 22 through the data storage layer 21 and may be electrically connected to the driving layer 11 through the core-periphery interconnection layer 12.

In some embodiments, when the memory chip 1000 is manufactured, the components of the cell chip 20 may be sequentially formed on the core-periphery chip 10. In other words, the cell semiconductor layer 200, the memory cell layer 210, and the cell interconnection layer 22 may be sequentially formed on the core-periphery chip 10. In this case, for example, the cell semiconductor layer 200 may be the semiconductor epitaxial layer. In certain embodiments, when the memory chip 1000 is manufactured, the data storage layer 21 may be formed using separate manufacturing processes and then may be bonded onto the core-periphery chip 10. In this case, for example, the cell semiconductor layer 200 may be the semiconductor substrate. However, embodiments of the present disclosure are not limited to the descriptions to the methods of manufacturing the memory chip 1000.

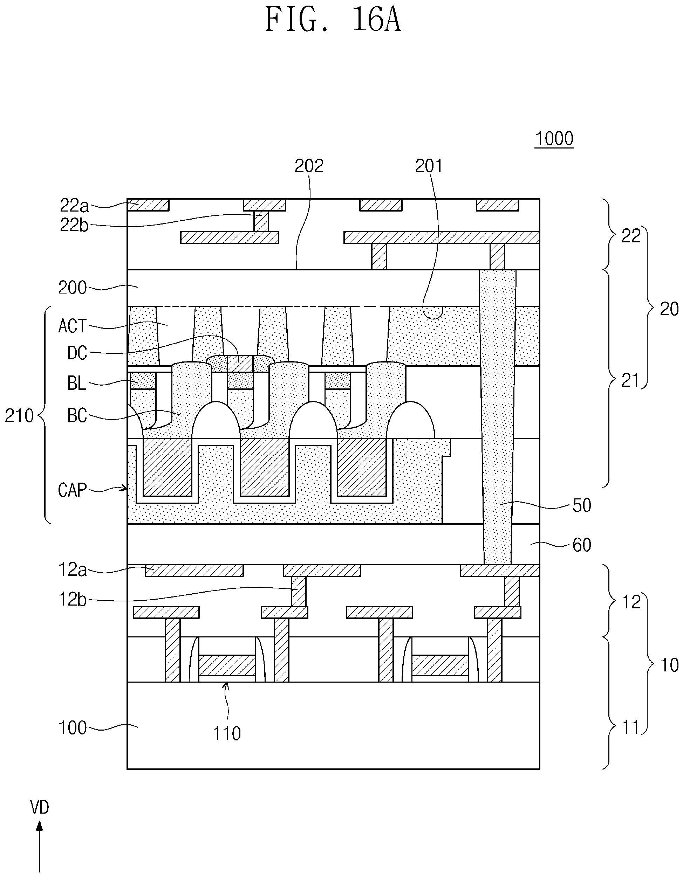

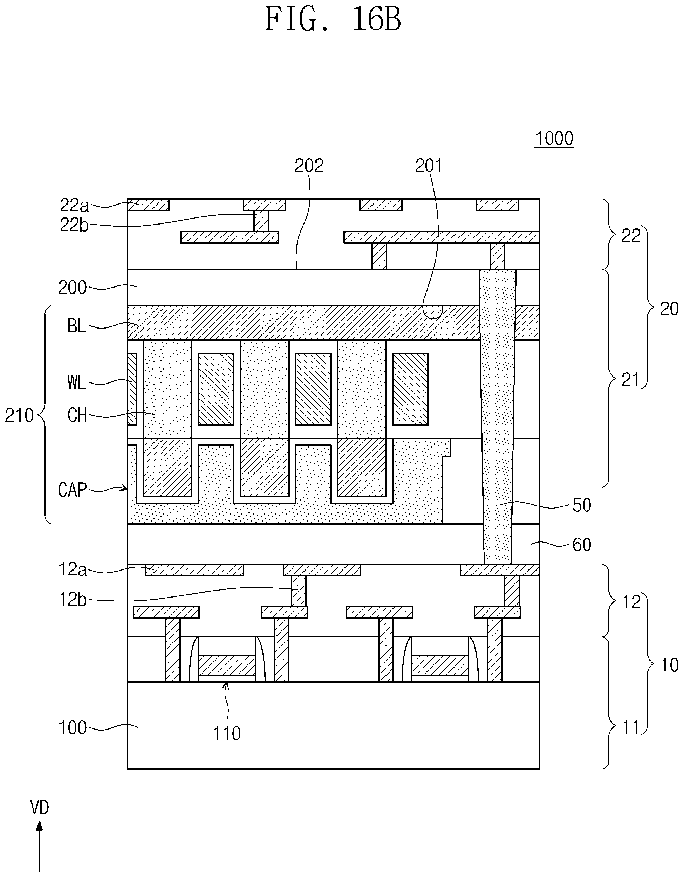

Referring to FIGS. 16A and 16B, like FIGS. 15A and 15B, the data storage layer 21 may be disposed on the core-periphery chip 10, and the cell interconnection layer 22 may be disposed on the data storage layer 21. The data storage layer 21 may be disposed between the core-periphery chip 10 and the cell interconnection layer 22.

However, unlike FIGS. 15A and 15B, the memory cell layer 210 may be disposed between the first surface 201 of the cell semiconductor layer 200 and the core-periphery chip 10, and the cell interconnection layer 22 may be disposed on the second surface 202 of the cell semiconductor layer 200. In other words, the memory cell layer 210, the cell semiconductor layer 200 and the cell interconnection layer 22 may be sequentially stacked on the core-periphery chip 10. The chip insulating layer 60 may be located on the first surface 201 of the cell semiconductor layer 200 and may be disposed between the memory cell layer 210 and the core-periphery chip 10. The through-conductive pattern 50 may electrically connect the core-periphery chip 10 to the cell chip 20.

In some embodiments, when the memory chip 1000 is manufactured, the data storage layer 21 may be formed using manufacturing processes different from processes of manufacturing the core-periphery chip 10 and then may be bonded onto the core-periphery chip 10. In this case, for example, the cell semiconductor layer 200 may be the semiconductor substrate. For example, the data storage layer 21 may be turned over and may be bonded onto the core-periphery chip 10. However, embodiments of the present disclosure are not limited to the descriptions to the method of manufacturing the memory chip 1000.

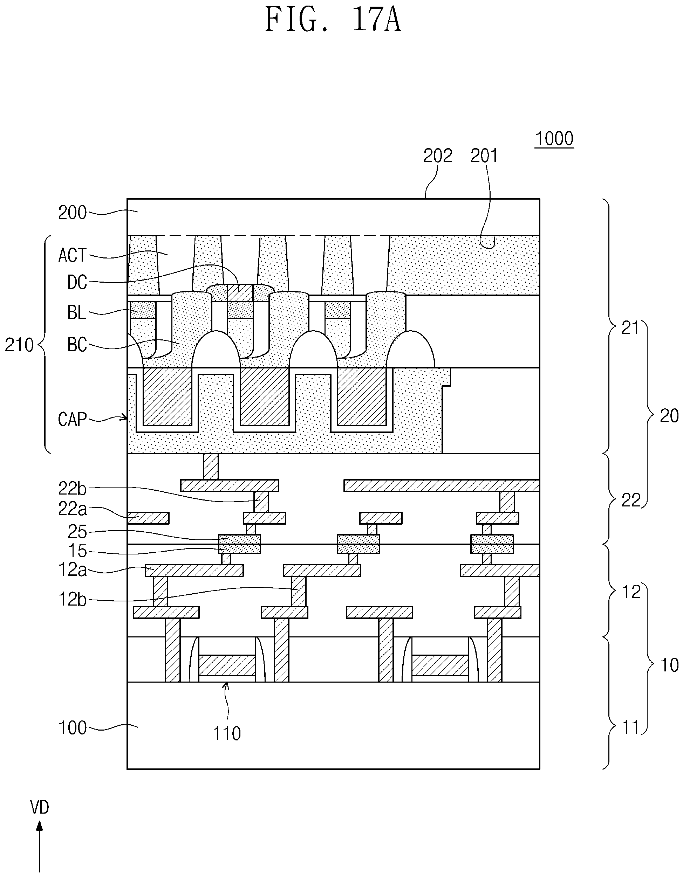

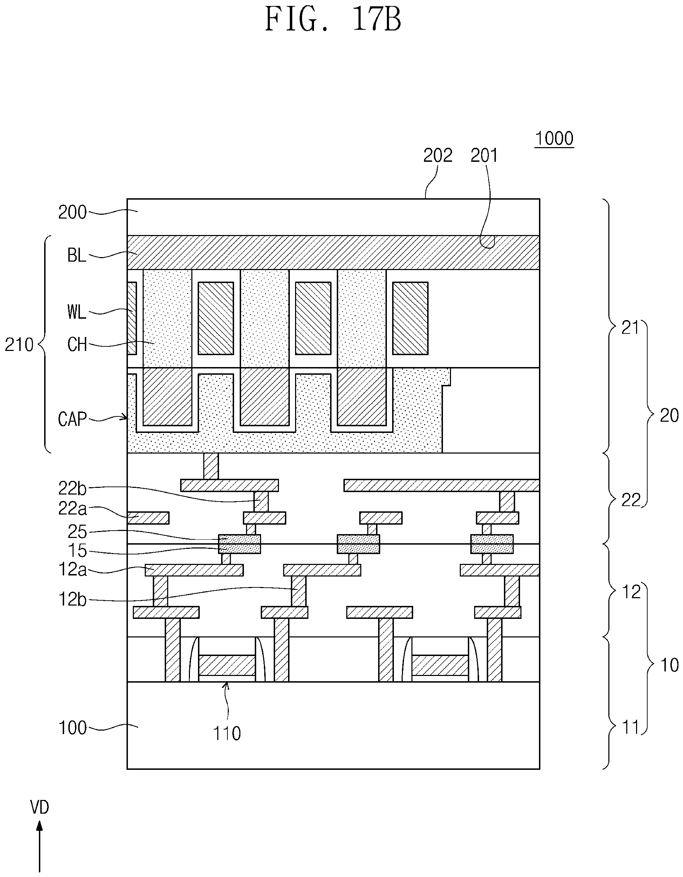

Referring to FIGS. 17A and 17B, unlike FIGS. 15A to 16B, the cell interconnection layer 22 may be disposed on the core-periphery chip 10, and the data storage layer 21 may be disposed on the cell interconnection layer 22. The cell interconnection layer 22 may be disposed between the data storage layer 21 and the core-periphery chip 10.

The memory cell layer 210 may be disposed between the first surface 201 of the cell semiconductor layer 200 and the core-periphery chip 10, and the cell interconnection layer 22 may be disposed between the memory cell layer 210 and the core-periphery chip 10. The cell interconnection layer 22, the memory cell layer 210, and the cell semiconductor layer 200 may be sequentially stacked on the core-periphery chip 10.

The core-periphery interconnection layer 12 may include a core-periphery bonding pad 15. The cell interconnection layer 22 may include a cell bonding pad 25. The core-periphery bonding pad 15 and the cell bonding pad 25 may be coupled to each other, and thus the core-periphery chip 10 and the cell chip 20 may be electrically connected to each other. For example, each of the core-periphery bonding pad 15 and the cell bonding pad 25 may include copper (Cu), but embodiments of the present disclosure are not limited thereto.

In some embodiments, when the memory chip 1000 is manufactured, the cell chip 20 may be formed using manufacturing processes different from processes of manufacturing the core-periphery chip 10 and then may be bonded onto the core-periphery chip 10. When the core-periphery chip 10 is manufactured, a surface of the core-periphery bonding pad 15 may be exposed to the outside. When the cell chip 20 is manufactured, a surface of the cell bonding pad 25 may be exposed to the outside. By a bonding process, the exposed surface of the core-periphery bonding pad 15 may be in contact with the exposed surface of the cell bonding pad 25, and the core-periphery bonding pad 15 and cell bonding pad 25 may be coupled to each other. For example, the cell chip 20 may be turned over and may be bonded onto the core-periphery chip 10. However, embodiments of the present disclosure are not limited to the descriptions to the method of manufacturing the memory chip 1000.

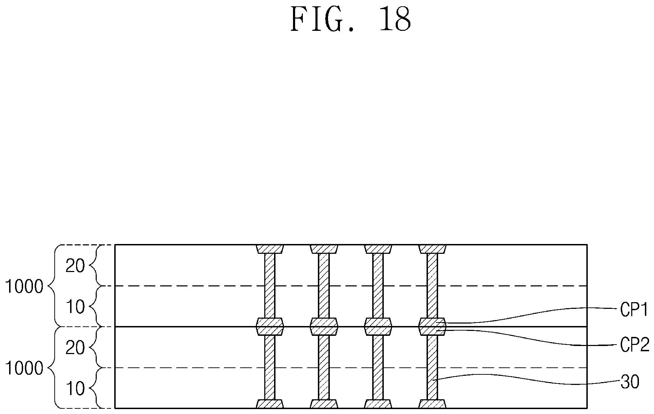

FIG. 18 is a cross-sectional view illustrating a plurality of memory chips according to some embodiments of the present disclosure.

Referring to FIG. 18, a plurality of memory chips 1000 may be vertically stacked. Each of the memory chips 1000 may be one of the memory chips 1000 described above. Each of the memory chips 1000 may include the core-periphery chip 10 and the cell chip 20, which are vertically stacked. The core-periphery chips 10 and the cell chips 20 may include the TSVs 30. The core-periphery chips 10 and the cell chips 20 may be alternately stacked. Two memory chips 1000 are illustrated in FIG. 18, but in certain embodiments, three or more memory chips 1000 may be stacked.

The memory chips 1000 may be electrically connected to each other through the TSVs 30. The TSVs 30 of each of the memory chips 1000 may include the TSVs 30 of the core-periphery chip 10 and the TSVs 30 of the cell chip 20. The TSV 30 of the core-periphery chip 10 is physically connected to the TSV 30 of the cell chip 20 in FIG. 18, but in certain embodiments, the TSV 30 of the core-periphery chip 10 and the TSV 30 of the cell chip 20 may be connected to each other through an additional contact provided therebetween.

The TSVs 30 of a pair of the memory chips 1000 stacked vertically may be electrically connected to each other through a first contact pad CP1 and a second contact pad CP2. The first contact pad CP1 and the second contact pad CP2 may be in contact with each other. The first contact pad CP1 and the second contact pad CP2 may each independently be a conductive pad or a conductive bump.

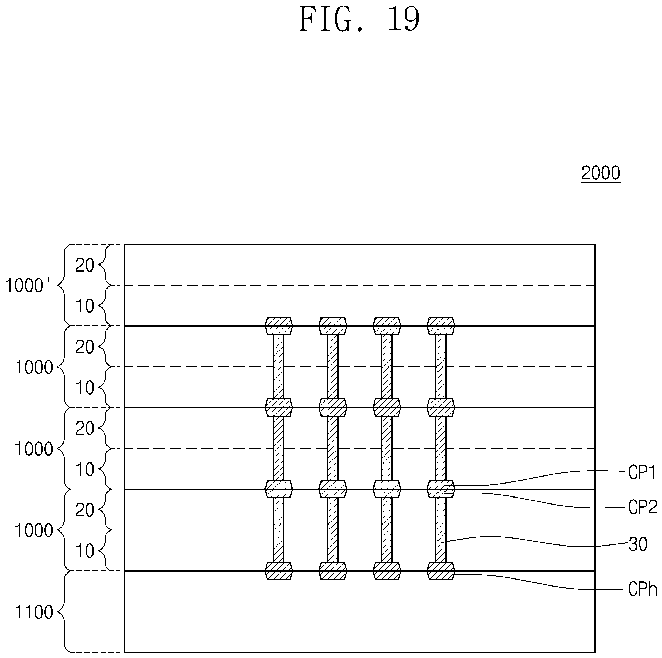

FIG. 19 is a cross-sectional view illustrating a semiconductor package including a memory chip according to some embodiments of the present disclosure.

Referring to FIG. 19, a semiconductor package 2000 may include a base chip 1100 and a plurality of memory chips 1000 and 1000' on the base chip 1100. The base chip 1100 may be electrically connected to the plurality of memory chips 1000 and 1000' and may include a host core or a buffer die. The host core may include a processor of performing various operations. The buffer die may receive commands, data and/or signals transmitted from the outside and may transmit the received commands, data and/or signals to the plurality of memory chips 1000 and 1000'. In other words, the plurality of memory chips 1000 and 1000' may be connected to the base chip 1100 and may be used to perform various operations in response to signals received from the base chip 1100.

The plurality of memory chips 1000 and 1000' may be electrically connected to the base chip 1100 through the TSVs 30. For example, the base chip 1100 may include a base contact pad CPh provided at its top end, and the TSVs 30 may be connected to the base chip 1100 through the base contact pad CPh. For example, the TSVs 30 may not be provided in an uppermost memory chip 1000', but embodiments of the present disclosure are not limited thereto.

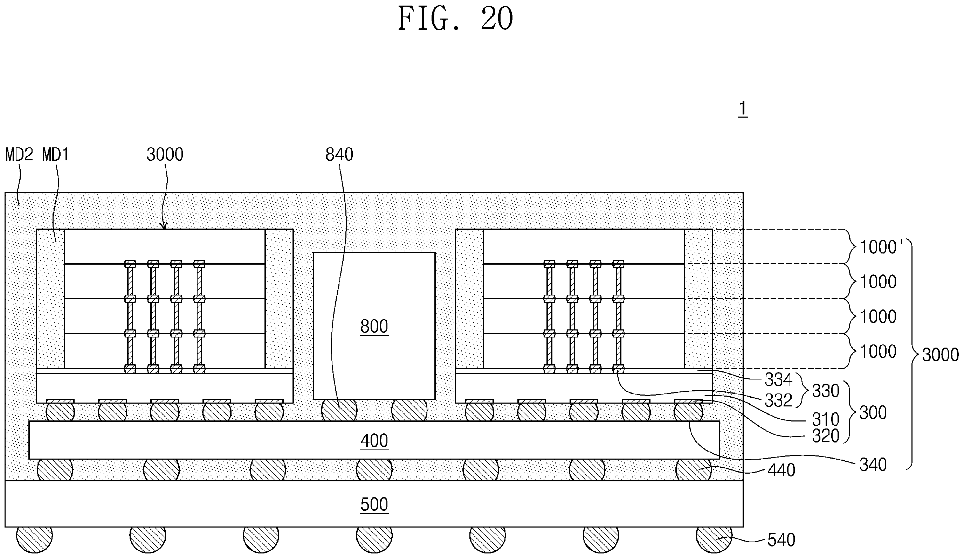

FIG. 20 is a cross-sectional view illustrating a semiconductor package including a memory chip according to some embodiments of the present disclosure.

Referring to FIG. 20, a semiconductor package 1 may include a package substrate, a memory structure 3000, and a host structure 800. The memory structure 3000 and the host structure 800 may be provided on the package substrate and may be horizontally spaced apart from each other. The memory structure 3000 and the host structure 800 may be electrically connected to each other through the package substrate.

In some embodiments, the package substrate may include a first package substrate 400 and a second package substrate 500. The first package substrate 400 may be located on the second package substrate 500, and the memory structure 3000 and the host structure 800 may be located on the first package substrate 400. The first package substrate 400 may be an interposer, and the second package substrate 500 may be a printed circuit board (PCB). A first connection terminal 440 may electrically connect the first package substrate 400 to the second package substrate 500. A second connection terminal 540 may electrically connect the semiconductor package 1 to an external device (e.g., a main board).

The memory structure 3000 may include a base chip 300, a plurality of memory chips 1000 and 1000' on the base chip 300, a first molding layer MD1 surrounding the plurality of memory chips 1000 and 1000', and a memory connection terminal 340 between the base chip 300 and the package substrate (e.g., the first package substrate 400 and the second package substrate 500). The base chip 300 may correspond to the base chip 1100 of FIG. 19.

The base chip 300 may include a base layer 310, an upper interconnection layer 330 formed on a surface (e.g., a top surface) of the base layer 310, and a lower base pad 320 exposed at another surface (e.g., a bottom surface) of the base layer 310. The upper interconnection layer 330 may include an upper base pad 332 and a base protective layer 334 surrounding the upper base pad 332.

The base chip 300 may redistribute the plurality of memory chips 1000 and 1000'. The upper base pad 332 and the lower base pad 320 may be electrically connected to each other through a circuit line in the base layer 310 and may constitute a redistribution circuit along with the circuit line. The memory connection terminal 340 may be located between the lower base pad 320 and the package substrate (e.g., the first package substrate 400 and the second package substrate 500). The memory connection terminal 340 may include a solder ball or a solder bump. The first molding layer MD1 may include an insulating material. For example, the first molding layer MD1 may include an epoxy molding compound (EMC).

The host structure 800 may be a data processing unit. A host connection terminal 840 may be disposed between the host structure 800 and the package substrate (e.g., the first package substrate 400 and the second package substrate 500). The host connection terminal 840 may electrically connect the host structure 800 to the package substrate (e.g., the first package substrate 400 and the second package substrate 500). A second molding layer MD2 may surround the memory structure 3000 and the host structure 800 on the package substrate (e.g., the first package substrate 400 and the second package substrate 500).

According to the present disclosure, the core-periphery chip 10 and the cell chip 20 may be vertically stacked, and thus the core region COR and the peripheral region PR may be defined on a plane located at a level different from a level of the cell region CR. As a result, an integration density in a unit area of the memory chip 1000 may be improved as compared with a case in which the cell region CR, the core region COR, and the peripheral region PR are defined on the same plane.

In addition, since the core-periphery chip 10 includes the NPU block NB, the NPU block NB may be disposed adjacent to the cell region CR. Thus, a data transmission distance between the NPU block NB and the cell region CR may be minimized, and the data processing speed of the memory chip 1000 may be improved. Furthermore, the memory chip 1000 may be driven by low power, and issues such as noise and/or heat generation may be reduced or minimized. As a result, the performance of the memory chip 1000 may be improved.

According to embodiments of the present disclosure, the core-periphery chip and the cell chip may be vertically stacked. Thus, the integration densities in unit areas of the memory chip and the semiconductor package including the same may be improved.

In addition, since the core-periphery chip includes the NPU block, the NPU block may be disposed adjacent to the cell region. Thus, the data transmission distance between the NPU block and the cell region may be minimized, and the data processing speed of the memory chip may be improved. As a result, the performance of the memory chip and the semiconductor package including the same may be improved.

Embodiments are set out in the following clauses:
Clause 1. A memory chip comprising:
   a cell chip; and
   a core-periphery chip,
   wherein the cell chip and the core-periphery chip are vertically stacked and are electrically connected to each other,
   wherein the cell chip comprises cell regions, each of the cell regions comprising a memory cell layer,
   wherein the core-periphery chip comprises at least one core group region and a peripheral region which are adjacent to each other in a first direction,
   wherein the at least one core group region comprises core regions arranged in a line in a second direction intersecting the first direction, and
   wherein each of the core regions comprises:
      a core bank comprising a core circuit; and
      a neural processing unit (NPU) block comprising an NPU.
Clause 2. The memory chip of clause 1, wherein the at least one core group region comprises a pair of core group regions spaced apart from each other in the first direction with the peripheral region interposed therebetween, and
   wherein the core banks and the NPU blocks of the pair of core group regions are symmetrical with respect to the peripheral region.
Clause 3. The memory chip of clause 1, wherein the at least one core group region comprises a pair of core group regions spaced apart from each other in the first direction with the peripheral region interposed therebetween, and
   wherein the core banks and the NPU blocks of the pair of core group regions are asymmetrical with respect to the peripheral region.
Clause 4. The memory chip of any preceding clause, wherein the core-periphery chip comprises a side surface facing the first direction, and
   wherein the at least one core group region comprises core group regions adjacent to each other in the first direction between the side surface of the core-periphery chip and the peripheral region.
Clause 5. The memory chip of clause 4, wherein the core banks and the NPU blocks of one of the core group regions and the core banks and the NPU blocks of another one of the core group regions, adjacent to the one of the core group regions, are symmetrical with respect to a line which is perpendicular to the first direction and passes through a center between the one and the another one of the core group regions.
Clause 6. The memory chip of clause 4, wherein the core banks and the NPU blocks of one of the core group regions and the core banks and the NPU blocks of another one of the core group regions, adjacent to the one of the core group regions, are disposed asymmetrically with respect to a line which is perpendicular to the first direction and passes through a center between the one and the another one of the core group regions.
Clause 7. The memory chip of any preceding clause, wherein each of the cell regions further comprises an NPU buffer.
Clause 8. The memory chip of clause 7, wherein the NPU buffer comprises at least one from among a phase-change random access memory (PRAM) device, a spin transfer torque magnetic RAM (STT-MRAM), and a ferroelectric RAM (FeRAM), and a static RAM (SRAM).
Clause 9. The memory chip of any preceding clause, wherein the memory cell layer comprises at least one from among a two-dimensional (2D) memory and a three-dimensional (3D) memory.
Clause 10. The memory chip of any preceding clause, wherein each of the cell regions vertically overlaps with at least a portion of one of the NPU blocks.
Clause 11. The memory chip of any preceding clause, wherein each of the cell chip and the core-periphery chip further comprises through-silicon vias (TSVs), and
   wherein the TSVs of the cell chip are electrically connected to the TSVs of the core-periphery chip.
Clause 12. The memory chip of clause 11, wherein the TSVs of the cell chip are in a central portion of the cell chip, and
   wherein the TSVs of the core-periphery chip are in a central portion of the core-periphery chip.
Clause 13. The memory chip of any preceding clause, wherein the cell chip and the core-periphery chip are electrically connected to each other through a through-conductive pattern penetrating the cell chip and the core-periphery chip.
Clause 14. The memory chip of any preceding clause, wherein the cell chip further comprises a cell bonding pad,
   wherein the core-periphery chip further comprises a core-periphery bonding pad, and
   wherein the cell bonding pad and the core-periphery bonding pad are coupled to each other such as to electrically connect the cell chip and the core-periphery chip.
Clause 15. The memory chip of any preceding clause, wherein the cell chip further comprises a cell semiconductor layer comprising a semiconductor material, and
   wherein the cell semiconductor layer is between the core-periphery chip and the memory cell layer.
Clause 16. The memory chip of any of clauses 1-14, wherein the cell chip further comprises a cell semiconductor layer comprises a semiconductor material, and
   wherein the memory cell layer is between the core-periphery chip and the cell semiconductor layer.
Clause 17. A semiconductor package comprising:
   cell chips;
   core-periphery chips; and
   through-silicon vias (TSVs) electrically connecting the cell chips and the core-periphery chips to each other,
   wherein the cell chips and the core-periphery chips are alternately stacked,
   wherein each of the cell chips comprises a cell region for storing data, and
   wherein each of the core-periphery chips comprises a neural processing unit (NPU) block that is configured to perform data operations.
Clause 18. The semiconductor package of clause 17, wherein each of the core-periphery chips further comprises:
   a core bank comprising a core circuit; and
   a peripheral region comprising a peripheral circuit.
Clause 19. A semiconductor package comprising:
   a plurality of memory chips stacked vertically; and
   through-silicon vias (TSVs) electrically connecting the plurality of memory chips,
   wherein each of the plurality of memory chips comprises a cell chip and a core-periphery chip which are vertically stacked,
   wherein the cell chip comprises: cell regions, each of the cell regions comprising a memory cell layer,
   wherein the core-periphery chip comprises at least one core group region and a peripheral region which are adjacent to each other in a first direction,
   wherein the at least one core group region comprises core regions arranged in a line in a second direction intersecting the first direction, and
   wherein each of the core regions comprises:
      a core bank comprising a core circuit; and
      a neural processing unit (NPU) block comprising an NPU.
Clause 20. The semiconductor package of clause 19, further comprising:
   a base chip comprising a host core or a buffer die,
   wherein the plurality of memory chips is on the base chip.
Clause 21. The semiconductor package of clause 19 or 20, wherein the TSVs penetrate central portions of the plurality of memory chips.
Clause 22. The semiconductor package of any of clauses 19-21, wherein the at least one core group region comprises a pair of core group regions spaced apart from each other in the first direction with the peripheral region interposed therebetween, and
   wherein the core banks and the NPU blocks of the pair of core group regions are symmetrical with respect to the peripheral region.
Clause 23. The semiconductor package of any of clauses 19-21, wherein the at least one core group region comprises a pair of core group regions spaced apart from each other in the first direction with the peripheral region interposed therebetween, and
   wherein the core banks and the NPU blocks of the pair of core group regions are asymmetrical with respect to the peripheral region.
Clause 24. The semiconductor package of any of clauses 19-23, wherein the core-periphery chip comprises a side surface facing the first direction, and
   wherein the at least one core group region comprises core group regions adjacent to each other in the first direction between the side surface of the core-periphery chip and the peripheral region.
Clause 25. The semiconductor package of any of clauses 19-24, wherein the memory cell layer comprises at least one from among a two-dimensional (2D) memory and a three-dimensional (3D) memory.
Clause 26. A semiconductor package comprising:
   a package substrate;
   a host structure on the package substrate; and
   a memory structure horizontally spaced apart from the host structure on the package substrate and electrically connected to the host structure,
   wherein the memory structure comprises a plurality of memory chips stacked vertically,
   wherein each of the plurality of memory chips comprises a cell chip and a core-periphery chip which are vertically stacked and are electrically connected to each other,
   wherein the cell chip comprises cell regions, each the cell regions comprising a memory cell layer,
   wherein the core-periphery chip comprises at least one core group region and a peripheral region which are adjacent to each other in a first direction,
   wherein the at least one core group region comprises core regions arranged in a line in a second direction intersecting the first direction, and
   wherein each of the core regions comprises:
      a core bank comprising a core circuit; and
      a neural processing unit (NPU) block comprising an NPU.
Clause 27. The semiconductor package of clause 26, wherein the memory structure further comprises through-silicon vias (TSVs) electrically connecting the plurality of memory chips.
Clause 28. The semiconductor package of any of clauses 26-27, wherein the memory structure comprises a plurality of memory structures horizontally spaced apart from each other.
Clause 29. The semiconductor package of any of clauses 26-28, wherein the memory cell layer comprises at least one from among a two-dimensional (2D) memory and a three-dimensional (3D) memory.
Clause 30. The semiconductor package of any of clauses 26-29, wherein the at least one core group region comprises a pair of core group regions spaced apart from each other in the first direction with the peripheral region interposed therebetween.

While non-limiting example embodiments of the present disclosure have been particularly shown and described, it will be understood by one of ordinary skill in the art that variations in form and detail may be made therein without departing from the scope of the present disclosure.

## Claims

1. A memory chip comprising:
a cell chip; and
a core-periphery chip,
wherein the cell chip and the core-periphery chip are vertically stacked and are electrically connected to each other,
wherein the cell chip comprises cell regions, each of the cell regions comprising a memory cell layer,
wherein the core-periphery chip comprises at least one core group region and a peripheral region which are adjacent to each other in a first direction,
wherein the at least one core group region comprises core regions arranged in a line in a second direction intersecting the first direction, and
wherein each of the core regions comprises:
a core bank comprising a core circuit; and
a neural processing unit, NPU, block comprising an NPU.

2. The memory chip of claim 1, wherein the at least one core group region comprises a pair of core group regions spaced apart from each other in the first direction with the peripheral region interposed therebetween, and
wherein the core banks and the NPU blocks of the pair of core group regions are symmetrical with respect to the peripheral region.

3. The memory chip of claim 1, wherein the at least one core group region comprises a pair of core group regions spaced apart from each other in the first direction with the peripheral region interposed therebetween, and
wherein the core banks and the NPU blocks of the pair of core group regions are asymmetrical with respect to the peripheral region.

4. The memory chip of any preceding claim, wherein the core-periphery chip comprises a side surface facing the first direction, and
wherein the at least one core group region comprises core group regions adjacent to each other in the first direction between the side surface of the core-periphery chip and the peripheral region.

5. The memory chip of any preceding claim, wherein each of the cell regions further comprises an NPU buffer.

6. The memory chip of claim 5, wherein the NPU buffer comprises at least one from among a phase-change random access memory device, a spin transfer torque magnetic random access memory, and a ferroelectric random access memory, and a static random access memory.

7. The memory chip of any preceding claim, wherein the memory cell layer comprises at least one from among a two-dimensional memory and a three-dimensional memory.

8. The memory chip of any preceding claim, wherein each of the cell regions vertically overlaps with at least a portion of one of the NPU blocks.

9. The memory chip of any preceding claim, wherein each of the cell chip and the core-periphery chip further comprises through-silicon vias, TSVs, and
wherein the TSVs of the cell chip are electrically connected to the TSVs of the core-periphery chip.

10. The memory chip of any preceding claim, wherein the cell chip and the core-periphery chip are electrically connected to each other through a through-conductive pattern penetrating the cell chip and the core-periphery chip.

11. The memory chip of any preceding claim, wherein the cell chip further comprises a cell bonding pad,
wherein the core-periphery chip further comprises a core-periphery bonding pad, and
wherein the cell bonding pad and the core-periphery bonding pad are coupled to each other such as to electrically connect the cell chip and the core-periphery chip.

12. The memory chip of any preceding claim, wherein the cell chip further comprises a cell semiconductor layer comprising a semiconductor material, and
wherein the cell semiconductor layer is between the core-periphery chip and the memory cell layer.

13. The memory chip of any of claims 1-11, wherein the cell chip further comprises a cell semiconductor layer comprises a semiconductor material, and
wherein the memory cell layer is between the core-periphery chip and the cell semiconductor layer.

14. A semiconductor package comprising:
a package substrate;
a host structure on the package substrate; and
a memory structure horizontally spaced apart from the host structure on the package substrate and electrically connected to the host structure,
wherein the memory structure comprises a plurality of memory chips stacked vertically,
wherein each of the plurality of memory chips is in accordance with any preceding claim.

15. The semiconductor package of claim 14, wherein the memory structure comprises a plurality of memory structures horizontally spaced apart from each other.
